# EUROPEAN PATENT APPLICATION

(11) **EP 1 351 171 A2**
(43) Date of publication of application: **08.10.2003**
(21) Application number: 03007439.7
(22) Date of filing: 03.04.2003
(51) Int. Cl.: G06F 17/50

(54) **Design method and design system for vehicular lamp, program to execute designing of vehicular lamp and record medium recording the program**

(30) Priority: 04.04.2002 JP 2002102914
(71) Applicant: Koito Manufacturing Co., Ltd., Tokyo 108-8711 (JP)
(72) Inventor: Otsuka, Yoshinori, Koito Manufacturing Co., Ltd., Shimizu-shi, Shizuoka 424-8764 (JP); Ishikawa, Masahito, Koito Manufacturing Co., Ltd., Shimizu-shi, Shizuoka 424-8764 (JP)
(74) Representative: HOFFMANN EITLE

(57) **Abstract**

Disclosed is to provide a design method and design system for a vehicular lamp, a program to execute designing of vehicular lamp and a record medium recording the program, which are capable of improving an efficiency of designing a lamp satisfying design conditions including performance conditions required as the vehicular lamp and restriction conditions given to each lamp. A vehicular lamp design system 1 includes: a database unit 2 having standard database 21 registering standard data corresponding to a selected standard lamp; and a lamp preparation unit 3 having a standard data selection part 31 and a morphing control part 32. The standard data selection part 31 generates design data by selecting one piece of standard data from a plurality of standard data registered in the standard database 21 based on design conditions given to the lamp. The morphing control part 32 updates a necessary part of the design data and prepares lamp data satisfying the design conditions.

## Description

### BACKGROUND OF THE INVENTION

### Field of the Invention

The present invention relates to a design method and design system for a vehicular lamp used for vehicles such as an automobile and relates to a program for allowing a computer to execute designing of the vehicular lamp and a computer-readable record medium recording the program.

### Related Background Art

Regarding a vehicular lamp, besides (1) conditions from aspects related to functions and performance as a lamp, because of its use in a state of being attached to a vehicle such as an automobile and the like, restriction conditions such as (2) conditions from aspects related to its shape (shape restriction conditions), (3) conditions from aspects related to its external appearance (appearance restriction conditions) and the like are imposed thereon. Therefore, in designing the lamp, it is required to realize a lamp in which the restriction conditions from given aspects of the shape and external appearance are satisfied and performance conditions thereof are optimized.

As the conditions from the aspect of performance, there are conditions from aspects of an optical performance such as a luminous intensity distribution pattern and the like, a structural performance, a thermal performance and the like, the conditions being required according to types of the lamp as the function of the vehicular lamp. Moreover, regarding the restriction conditions from the aspect of a car body, as the shape restriction conditions, there are conditions related to volume and shape of a lamp housing portion provided in the car body, to a shape of a lens outer surface of the lamp, the shape being continuous with other portions of the car body, and the like. Moreover, as the appearance restriction conditions, there are conditions related to a harmony between the external appearance thereof and an external appearance of the other portions of the car body, to a design of the car body and the like.

### SUMMARY OF THE INVENTION

The restriction conditions upon designing, such as the shape and appearance restriction conditions and the like with respect to the vehicular lamp, are usually given as individual design conditions for every lamp according to the shape and external appearance designs of the car body using the lamp. Therefore, in designing such a lamp, it is necessary to consider the restriction conditions given to the lamp to be designed and to design the lamp so as to satisfy performance conditions necessary as the vehicular lamp regarding each performance such as the optical performance as to light emitted from the lamp.

Constitution, shape and the like of such a vehicular lamp are designed so as to satisfy the restriction conditions given thereto, while referring, to some degree, to necessary performance conditions such as a luminous intensity distribution pattern, for example, having certain light uniformity and light diffusion, as to a design procedure of the lamp. Then, for the designed lamp, the performance thereof is evaluated by performing a simulation of the luminous intensity distribution and the like. When the lamp does not satisfy the necessary performance conditions in the evaluation result, the lamp is redesigned by changing a part of the constitution, shape and the like of the evaluated lamp or by starting over the design of the lamp.

However, by use of such a design method, there is a problem that a design efficiency of the lamp is lowered due to the contents of the restriction conditions given to the lamp, a specific procedure used in the steps of designing or redesigning the lamp and the like. For example, when the constitution of the lamp designed so as to satisfy the restriction conditions from the aspect of the car body is depart from a constitution satisfying performance conditions necessary in the early stage, redesigning thereof is repeated many times until a lamp satisfying the performance conditions is finally obtained. Thus, the design efficiency of the lamp is significantly lowered.

The present invention is made in order to solve the above-described problems. It is the object of the present invention to provide a method for designing a vehicular lamp, a design system, a program for allowing a computer to execute designing of the vehicular lamp and a record medium recording the program. Specifically, the design method for the vehicular lamp is capable of improving a design efficiency of a lamp satisfying design conditions including performance conditions required as the vehicular lamp and restriction conditions given to each lamp.

In order to achieve the above-described object, the design method for a vehicular lamp according to the present invention is a method for designing a vehicular lamp, the method comprising the steps of: (1) previously registering standard data in a standard database, the standard data being prepared in a predetermined data format having at least constitution data about a constitution of a standard lamp selected from lamps already designed; and (2) generating design data by selecting one piece of standard data from the plurality of standard data registered in the standard database based on design conditions including a performance condition required as the vehicular lamp and a restriction condition given to each lamp and preparing lamp data satisfying the design conditions by updating a necessary part of the design data.

Moreover, the design system for a vehicular lamp according to the present invention is a system for designing a vehicular lamp, the system comprising: (1) a standard database previously registering standard data prepared in a predetermined data format having at least constitution data about a constitution of a standard lamp selected from already designed lamps; and (2) lamp preparation means for generating design data by selecting one piece of standard data from the plurality of standard data registered in the standard database based on design conditions including a performance condition required as a vehicular lamp and a restriction condition given to each lamp and for preparing lamp data satisfying the design conditions by updating a necessary part of the design data.

Moreover, the program according to the present invention is a program for allowing a computer to execute designing of a vehicular lamp, the program being for allowing the computer to execute: (1) a lamp preparation processing in which design data are generated by selecting one piece of standard data from a plurality of standard data registered in a standard database based on design conditions including a performance condition required as the vehicular lamp and a restriction condition given to each lamp and lamp data satisfying the design conditions are prepared by updating a necessary part of the design data; wherein (2) the standard database is a database previously registering the standard data prepared in a predetermined data format having at least constitution data about a constitution of a standard lamp selected from lamps already designed.

Moreover, the record medium according to the present invention is a computer-readable record medium recording a program for allowing a computer to execute designing of a vehicular lamp, the program being for allowing the computer to execute: (1) a lamp preparation processing in which design data are generated by selecting one piece of standard data from a plurality of standard data registered in a standard database based on design conditions including a performance condition required as the vehicular lamp and a restriction condition given to each lamp and lamp data satisfying the design conditions are prepared by updating a necessary part of the design data; wherein (2) the standard database is a database previously registering the standard data prepared in a predetermined data format having at least constitution data about a constitution of a standard lamp selected from already designed lamps.

In the above-described design method and design system for a vehicular lamp, program to execute designing of vehicular lamp and record medium recording the program, regarding the design of the vehicular lamp, a standard lamp utilizable as a model of the designing is selected from already designed lamps. Then, a standard database is prepared previously, which registers standard data that are lamp data corresponding to the standard lamp, and the lamp data are prepared by using these standard data as source data.

Here, the standard lamp selected from the already designed lamps is usually designed so as to satisfy performance conditions required as a vehicular lamp, such as a luminous intensity distribution pattern and the like. Therefore, by converting the lamp data of the standard lamp into a database and utilizing the database as the source data of the designing of the lamp, it is made possible to improve the design efficiency of the lamp satisfying the design conditions including the performance conditions and the restriction conditions.

Moreover, as to the standard data registered in the standard database, the lamp data are prepared in a uniform data format with respect to each standard lamp and the lamp is designed by use of the lamp data as the design data. Thus, a preparation procedure of the lamp data taking the standard data as the source data is simplified. Moreover, adoption of the data format as described above is useful from the viewpoint of sharing of the lamp data among respective workers designing the lamp, manufacturing the lamp or the like, or from the viewpoint of utilization of the lamp data after the designing thereof.

### BRIEF DESCRIPTION OF THE DRAWINGS

FIG. 1 is a block diagram showing a constitution of a design system of a vehicular lamp according to one embodiment.
FIG. 2 is a block diagram showing one example of a hardware configuration used in the design system of the vehicular lamp shown in FIG. 1.
FIG. 3 is a flowchart schematically showing one embodiment of a method for designing the vehicular lamp.
FIG. 4 is a schematic view showing one example of a data format of standard data registered in a standard database in the design system of the vehicular lamp shown in FIG. 1.
FIG. 5 is a schematic view showing one example of a data format of constitution data in the standard data shown in FIG. 4.
FIG. 6 is a schematic view showing one example of a data format of performance data in the standard data shown in FIG. 4.
FIG. 7 is a view showing one example of a design screen for selecting the standard data.
FIG. 8 is a view showing another example of a design screen for selecting the standard data.
FIG. 9 is a view showing one example of a design screen for confirming or updating design data.

### DESCRIPTION OF THE PREFERRED EMBODIMENTS

Hereinafter, detailed description will be made with reference to the drawings for preferred embodiments of a design method and design system for a vehicular lamp, a program for allowing a computer to execute designing of the vehicular lamp and a computer-readable record medium recording the program according to the present invention. Note that, in the description of the drawings, the same constituent components are denoted by the same reference numerals and thus repetitive description thereof will be omitted. Moreover, dimensional ratios of the drawings do not necessarily coincide with those in the description.

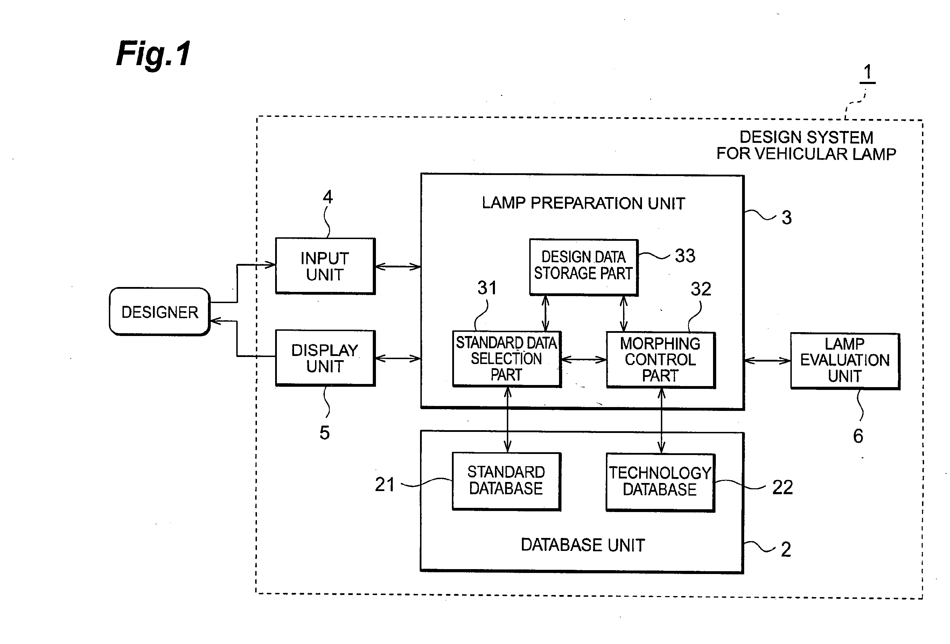

FIG. 1 is a block diagram showing a constitution of one embodiment of a design system of a vehicular lamp according to the present invention. This vehicular lamp design system 1 is a design system for preparing lamp data based on design conditions given to a vehicular lamp to be designed, the system being constituted of a database unit 2, a lamp preparation unit 3, an input unit 4 and a display unit 5.

The database unit 2 is a data storage unit storing data used for preparing the lamp data in this design system 1. In this embodiment, two kinds of database, including a standard database 21 and a technology database 22, are prepared in the database unit 2. The standard database 21 is a database storing standard data utilized in designing of the lamp as source data of the prepared lamp data. Moreover, the technology database 22 is a database storing technology data utilized in a preparation procedure of final lamp data satisfying the design conditions.

The lamp preparation unit 3, by use of the data stored in the database unit 2 and the like, prepares the lamp data based on an instruction from a designer or by an automatic processing. This lamp preparation unit 3 has a standard data. selection part 31, a morphing control part 32 and a design data storage part 33.

The standard data selection part 31 selects one piece of standard data suitable for the lamp from the plurality of standard data registered in the standard database 21, based on the design conditions for the lamp to be designed. Then, by use of the selected standard data, the design data used for preparing the lamp data are generated.

The morphing control part 32 performs morphing for the generated design data according to need. Specifically, as to a necessary part of the design data generated from the standard data, a part of or all of the design data are updated by performing modifications of the data, such as a change in the constitution of the lamp, a change in shape thereof and the like. Thus, the lamp data satisfying the design conditions are prepared.

Moreover, the design data generated from the standard data selected by the standard data selection part 31 and the design data partially or entirely updated by the morphing control part 32 are stored in the design data storage part 33. The stored data are referred to or updated according to need.

The input unit 4 and the display unit 5 are provided for the lamp preparation unit 3 preparing the lamp data based on the given design conditions, in order to exchange necessary information between the designer designing the lamp and the lamp preparation unit 3 of the design system 1. The input unit 4 is input means used by the designer to input information related to the designing of the lamp to the lamp preparation unit 3. Moreover, the display unit 5 is display means for displaying information referred to in the designing of the,lamp from the lamp preparation unit 3 to the designer.

To be specific, the designer can instruct, via the input unit 4, the standard data selection part 31 of the lamp preparation unit 3 to select one piece of standard data to be the design data from the plurality of standard data registered in the standard database 21. In this event, the input unit 4 functions as selection instruction means of the standard data. Moreover, the designer can instruct, via the input unit 4, the morphing control part 32 of the lamp preparation unit 3 to update a necessary part of the design data generated from the standard data. In this event, the input unit 4 functions as update instruction means of the design data.

Meanwhile, the display unit 5 functions as the display means for displaying, by use of the lamp preparation unit 3, a design screen showing necessary information to the designer. For example, regarding the selection of the standard data, the display unit 5 displays the plurality of standard data registered in the standard database 21, as options of the design data. Moreover, regarding the updating of the design data, the display unit 5 displays information necessary for the updating of the design data.

Moreover, in the design system 1 of this embodiment, a lamp evaluation unit 6 is provided for the foregoing lamp preparation unit 3. As to the lamp data such as the design data generated in the standard data selection part 31 of the lamp preparation unit 3, the design data updated in the morphing control part 32, the lamp evaluation unit 6 performs evaluation of the lamp based on the instruction from the designer or by an automatic processing. Specifically, the lamp evaluation unit 6 evaluates whether or not the lamp to be designed satisfies the given design conditions.

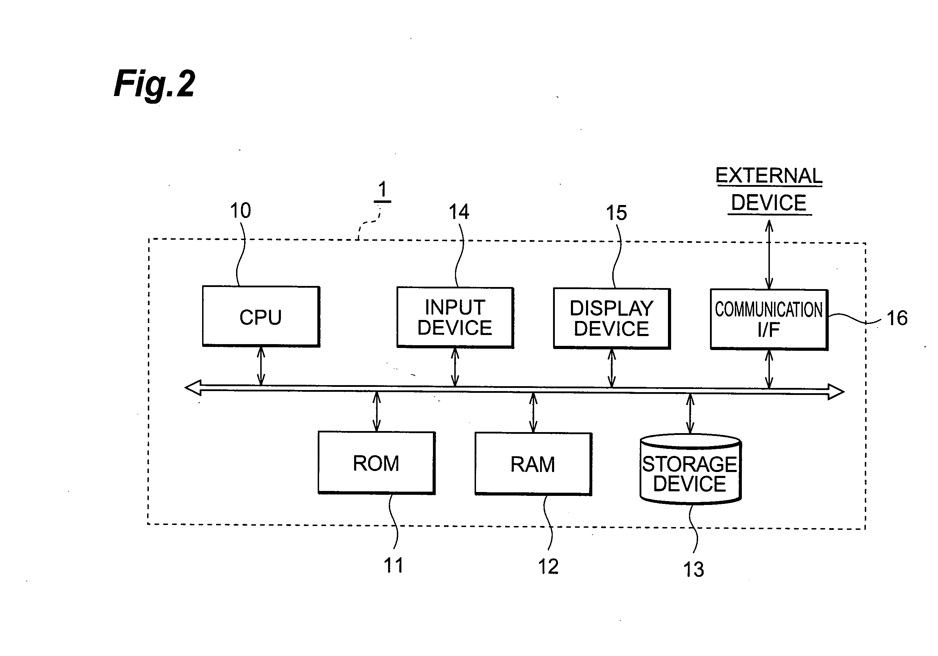

FIG. 2 is a block diagram showing one example of a hardware configuration used in the design system of the vehicular lamp shown in FIG. 1. Software processing activities in the design system 1 shown in FIG. 1 and processing corresponding to respective steps in the design method for a vehicular lamp, which is performed by this design system 1, are feasible by a program for allowing a computer to execute designing of the vehicular lamp. Specifically, the software processing activities include: the selection of the standard data and the generation of the design data in the standard data selection part 31; the update of the design data in the morphing control part 32; the reception of the input from the input unit 4; the instruction of the display to the display unit 5; and the like. In other words, these software processing activities are carried out, for example, by a CPU 10 executing the program for designing the vehicular lamp in the hardware configuration shown in FIG. 2.

To the CPU 10, connected are: a ROM 11 storing respective software programs necessary for processing operations of the design system 1; and a RAM 12 temporarily storing data during execution of the program. Moreover, to the CPU 10, an external storage device 13, such as a hard disc and the like, is connected. This external storage device 13 is used as a storage device storing respective data such as the data stored in the database unit 2 including the standard database 21 and the technology database 22, the design data stored in the design data storage part 33 and the like.

To the above-described devices such as the CPU 10, an input device 14 corresponding to the input unit 4 of FIG. 1 and a display device 15 corresponding to the display unit 5 are connected. Thus, the vehicular lamp design system 1 of this embodiment is constituted. As the input device 14, for example, a pointing device such as a mouse, a keyboard or the like is used. Moreover, as the display device 15, a CRT display, a liquid crystal display or the like is used. Moreover, when it is necessary to exchange the lamp data and the like between the design system 1 and an external device used by another designer or the like, a communication I/F 16 is provided for connection to the external device.

Moreover, the foregoing designing program for allowing the CPU 10 to execute the respective processing for designing the vehicular lamp is distributable by being recorded in a computer-readable record medium. Such a record medium includes, for example: a magnetic medium such as a hard disc, a floppy disk and the like; an optical medium such as a CD-ROM, a DVD-ROM and the like; a magneto-optical medium such as a floptical disk and the like; a hardware device such as, for example, a RAM, a ROM, a semiconductor nonvolatile memory and the like, which is specially disposed so as to execute or store program instructions; and the like. Moreover, a drive for reading recording media (for example, a floppy disk drive and the like) that reads the program and the like from the record medium described above may be connected to the CPU 10.

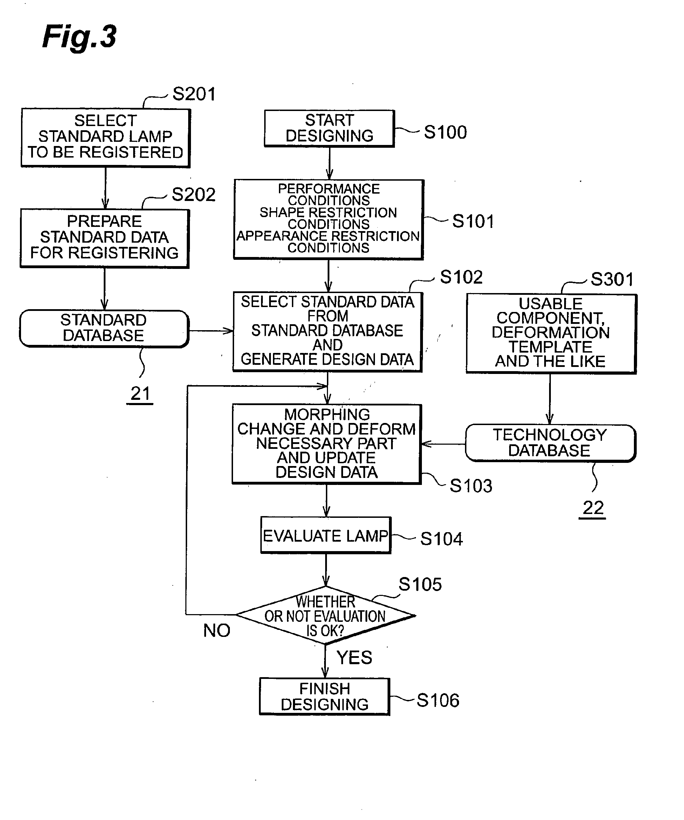

FIG. 3 is a flowchart schematically showing one embodiment of the design method for a vehicular lamp according to the present invention. With reference to the constitution of the design system 1 shown in FIG. 1, the design method for a vehicular lamp will be described below.

First, the standard database 21 and the technology database 22 will be described, which are prepared in the database unit 2 as the data used in preparing the lamp data in the design system 1. These databases 21 and 22 are prepared prior to the designing of the lamp and stored in the database unit 2 of the design system 1.

In the standard database 21, the plurality of standard data that can be used as the source data of the lamp data to be prepared in designing the lamp are stored. In preparation of the standard database, constitutions, shapes, external appearances, performances, manufacturing costs and the like of designed lamps, which are already designed or commercialized, are examined. Then, among those designed lamps, a lamp considered to be appropriate to be used as a model of designing the lamp is selected, thus obtaining a standard lamp (Step S201).

Next, for the selected standard lamp, standard data including information about a constitution thereof and the like, which are necessary upon designing thereof, is prepared (S202). These standard data are to be lamp data for registering to the standard database 21. Moreover, the standard data are prepared by use of a predetermined data format having at least constitution data about the constitution of the standard lamp. Note that the data format of the standard data registered in the standard database 21 will be described later.

Meanwhile, in the technology database 22, stored is technology data that can be utilized as data for updating the design data by changing the constitution of the lamp, components, shape, materials and the like in the designing of the lamp. As such technology data, for example, there are; data of components that can be used in the lamp; data of a template for changing shapes of respective parts of the lamp; and the like (S301).

Next, description will be made for the design method for a vehicular lamp, which utilizes the data stored in the standard database 21 and the technology database 22. First, according to an order from a client and the like, designing of a vehicular lamp is started (Step S100). In this event, to a lamp to be designed, design conditions, which are conditions that should be satisfied by the lamp, are given (S101). These design conditions include performance conditions and restriction conditions.

The performance conditions are conditions required from the aspects of functions and performance as the vehicular lamp. As specific performance conditions, there are conditions for: optical performance such as a luminous intensity distribution pattern required depending on the type of the lamp as functions of the vehicular lamp; structural performance such as a structural strength of the lamp and the like; thermal performance such as heat resistance in the state of turning on the lamp; and the like.

Moreover, the restriction conditions are conditions given from the aspect of the car body and the like as design conditions for each lamp. As specific restriction conditions, as shape restriction conditions from the aspect of shape thereof, there are conditions for: volume and shape of a lamp housing portion provided in the car body; a shape of a lens outer surface of the lamp, the shape being continuous with other portions of the car body; and the like. Moreover, as appearance restriction conditions from the aspect of external appearance thereof, there are conditions for: a harmony between the external appearance thereof and an external appearance of the other portions of the car body; a design of the car body; and the like.

Based on the design conditions including the performance conditions required as the vehicular lamp and the restriction conditions given to each lamp, the plurality of standard data registered in the standard database 21 are examined, respectively, and one piece of standard data, which will be used as the source data for designing the lamp, is selected from the standard data (S102).

By referring to the contents of the design screen displayed on the display unit 5, the designer selects standard data from the standard database 21, the standard data being suitable as the source data for preparing lamp data. Then, via the input unit 4, the designer instructs the standard data selection part 31 of the lamp preparation unit 3 about the standard data to be selected. Based on the contents of the input from the input unit 4, the standard data selection part 31 reads out the instructed standard data from the standard database 21, generates design data used for preparing the lamp data and stores the design data in the design data storage part 33.

Next, the design conditions and constitution and performance of the generated design data are examined, a necessary part of the design data is updated and thus the lamp data satisfying the design conditions is prepared (S103). Regarding the above-described updating of the design data, in the design system 1 shown in FIG. 1, the technology database 22 is prepared together with the standard database 21 in the database unit 2.

With reference to the contents of the design screen displayed on the display unit 5, the design conditions for the lamp to be designed and the like, the designer instructs the morphing control part 32 of the lamp preparation unit 3 to update the design data via the input unit 4 by utilizing the technology data stored in the technology database 22 according to need. Based on the contents of the input from the input unit 4, the morphing control part 32 reads out the instructed technology data from the technology database 22, performs morphing of the data, updates a necessary part of the design data and stores the updated data in the design data storage part 33.

Subsequently, for the lamp data prepared by the selection of the standard data, the generation of the design data and the updating, all of which are carried out by the lamp preparation unit 3, the lamp evaluation unit 6 evaluates performance of the lamp and the like (S104). Then, based on the obtained evaluation results, it is determined whether or not the lamp according to the prepared lamp data satisfies the design conditions given to the lamp (S105). If the design conditions are satisfied, the design data at the point is taken as final lamp data, thus finishing the designing of the lamp (S106). On the other hand, if the design conditions are not satisfied, the design procedure such as the updating of the design data and the like is repeated.

Description will be made for effects of the a design method and design system for a vehicular lamp, a program to execute designing of vehicular lamp and a record medium recording the program according to the above-described embodiment.

In the design system 1 and the design method for the vehicular lamp, which are shown in FIGS. 1 and 3, the program used therein and the record medium used therein, regarding the designing of the vehicular lamp, a standard lamp utilizable as a model of the designing is selected from already designed lamps. Then, the standard database 21, in which the standard data that are the lamp data corresponding to the standard lamp are registered, is previously prepared in the database unit 2, and the lamp data are prepared by using these standard data as the source data in the lamp preparation unit 3.

Here, the standard lamp selected from the already designed lamps is usually designed so as to satisfy performance conditions required as a vehicular lamp, such as a luminous intensity distribution pattern and the like. Therefore, by converting the lamp data of the standard lamp into database in the standard database 21 and utilizing the database as the source data of the designing of the lamp, it is made possible to improve the design efficiency of the lamp satisfying the design conditions including the performance conditions and the restriction conditions.

Moreover, as to the standard data registered in the standard database 21, the lamp data are prepared in a uniform data format with respect to each standard lamp and the lamp is designed by use of the lamp data as the design data. Thus, regardless of the type of the standard lamp selected as a model of the lamp, confirmation, updating and the like of the design data can be performed by taking a similar procedure. Thus, the preparation procedure of the lamp data using the standard data as the source data is simplified.

Moreover, the adoption of the data format as described above is useful from the viewpoint of sharing of the lamp data among respective workers designing the lamp, manufacturing the lamp or the like, or from the viewpoint of utilization of the lamp data after the designing thereof. For example, by preparing the lamp data corresponding to the lamp, which is already designed or is being designed, in a uniform data format, the respective workers can refer to or utilize the lamp data.

Moreover, in the design system 1 shown in FIG. 1, for the lamp preparation unit 3, provided are: the display unit 5 functioning as the display means for displaying design screens, and the like, which show the plurality of standard data registered in the standard database 21; and the input unit 4 functioning as the selection instruction means for instructing one piece of the standard data to be selected from the plurality of standard data, and the like. By providing the above-described input unit 4 and display unit 5, the designer performing the designing of the lamp can efficiently carry out design procedures, such as the selection of the standard data and the like, with reference to the design screen displayed on the display unit 5.

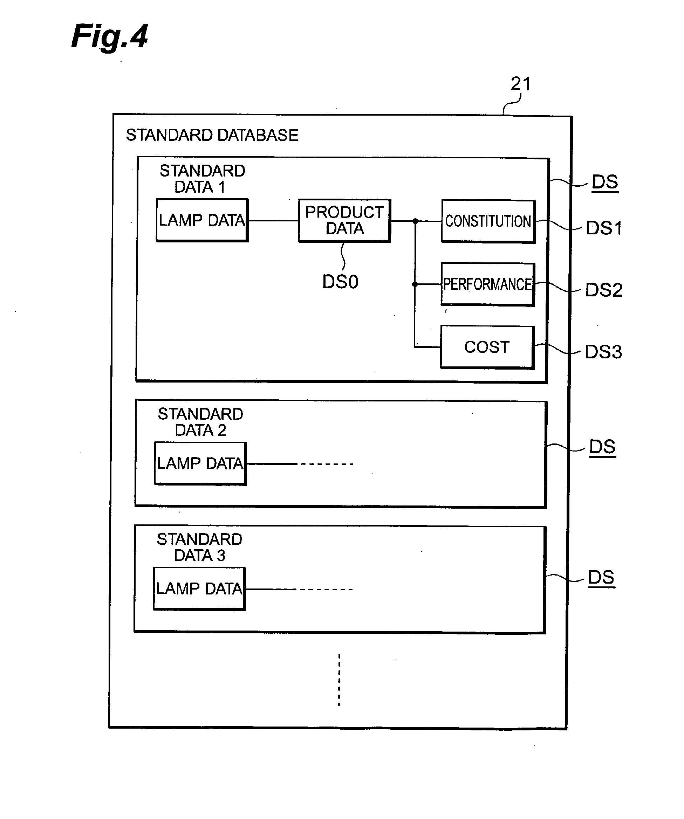

The standard data of the lamp, which is registered in the standard database 21 in the vehicular lamp design system 1 shown in FIG. 1, will be described in detail. FIG. 4 is a schematic view showing one example of a data format of the standard data registered in the standard database in the design system of the vehicular lamp shown in FIG. 1.

In the standard database 21, as shown in FIG. 4, a plurality of standard data DS, which can be used as source data for preparing lamp data, respectively, are registered. These standard data DS are composed of lamp data prepared in a predetermined data format as data corresponding to a standard lamp selected from designed lamps.

In the data format shown in the example of FIG. 4, the lamp data of the standard data DS are composed of product data DS0 that are data about a product itself of the lamp. Moreover, these product data DS0 are constituted by having three kinds of data including: constitution data DS1 about a constitution of the lamp; performance data DS2 about performance of the lamp; and cost data DS3 about manufacturing costs in manufacturing the lamp.

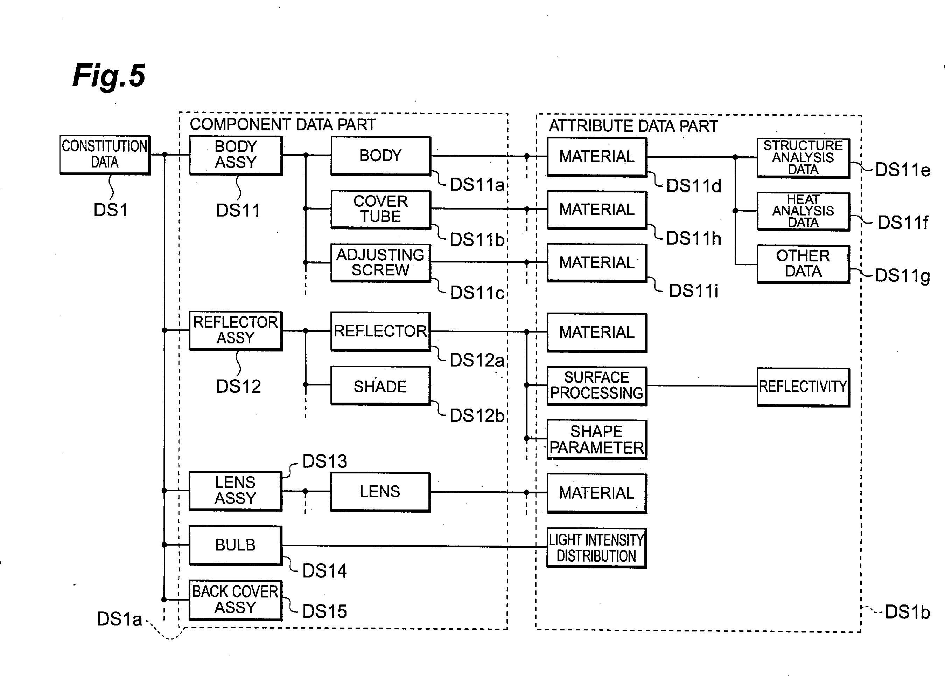

FIG. 5 is a schematic view partially showing one example of a data format of the constitution data in the standard data shown in FIG. 4. The constitution data DS1 are prepared in a data format of a hierarchical type, having: a component data part DS1a including necessary data about components used for the standard lamp; and an attribute data part DS1b including necessary data about attributes of the components in the component data part DS1a.

In the example shown in FIG. 5, the component data part DS1a has: body assembly data DS11 about a component constitution of a body portion of the lamp; reflector assembly data DS12 about a component constitution of a reflector portion; lens assembly data DS13 about a component constitution of a lens portion such as an inner lens, an outer lens or the like; bulb data DS14 about components of a light source bulb; and back cover assembly data DS15 about a component constitution of a rear cover portion.

Moreover, among these component data DS11 to DS15, as to the component data that are not the data of the components themselves but are the data of the component constitutions, there further exist component data, respectively, as low-order data thereof. In FIG. 5, for example, the body assembly data DS11 has, as low-order component data thereof, body data DS11a, cover tube data DS11b and adjusting screw data DS11c. Moreover, the reflector assembly data DS12 has reflector data DS12a and shade data DS12b.

For the above-described component data included in the component data part DS1a, attribute data about the attributes of the components in the respective component data are prepared in the attribute data part DS1b.

For example, when checking attribute data, that is low-order data for the body assembly data DS11 in the component data part DS1a, among the attribute data in the attribute data part DS1b, for the body data DS11a, the cover tube data DS11b and the adjusting screw data DS11c, material data DS11d, DSllh and DS11i about component materials as the attributes thereof are prepared, respectively. Specifically, the body data DS11a, the cover tube data DS11b and the adjusting screw data DS11c are the component data constituting the body.

Moreover, for the body data DS11a, in addition to the material data DS11d, structure analysis data DS11e, heat analysis data DS11f and other data DS11g are prepared as low-order attribute data thereof. Moreover, also for the respective component data DS12 to DS15 other than the body assembly data DS11, necessary attribute data are similarly prepared in the attribute data part DS1b.

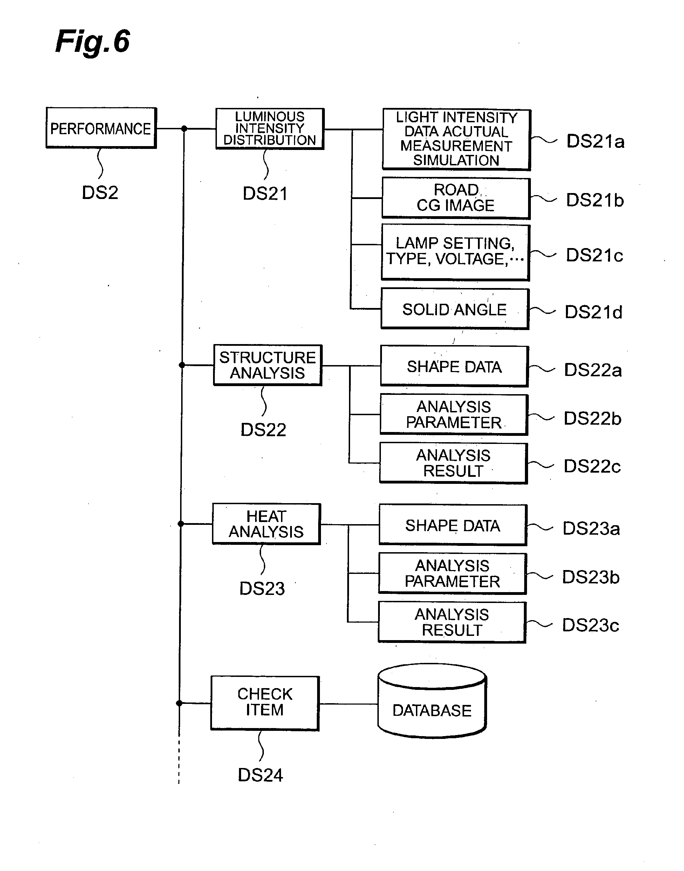

FIG. 6 is a schematic view partially showing one example of a data format of the performance data in the standard data shown in FIG. 4.

In the example shown in FIG. 6, the performance data DS2 has: luminous intensity distribution data DS21 about optical performance of a lamp, such as a luminous intensity distribution pattern of emitted light and the like; structure analysis data DS22 about structural performance such as a structural strength of the lamp and the like; heat analysis data DS23 about thermal performance such as heat resistance of the lamp; and check item DS24 showing check contents about the lamp and the like.

Moreover, for these performance data, specific data related to the respective performance data are prepared as low-order data.

For example, for the luminous intensity distribution data DS21, light intensity data DS21a, road surface CG image data DS21b, lamp setting data DS21c and solid angle data DS21d are prepared as low-order performance data thereof. Moreover, for the structure analysis data DS22, shape data DS22a, analysis parameter data DS22b and analysis result data DS22c are prepared. Moreover, for the heat analysis data DS23, shape data DS23a, analysis parameter data DS23b and analysis result data DS23c are prepared.

In data examples shown in FIGS. 4 to 6, the standard data DS is prepared in a data format having the performance data DS2 about the performance of the lamp in addition to the constitution data DS1 about the constitution of the lamp. Thus, in the designing of the lamp, the performance of the standard lamp as the source of the design data can be referred to.

Moreover, in the case where the performance of the lamp is evaluated after the necessary part of the design data are updated, the performance thereof can be efficiently evaluated by utilizing the performance data DS2 prepared together with the constitution data DS1 in the standard data DS. For example, in the performance data DS2 shown in FIG. 6, the performance data such as the shape data DS22a and DS23a, the analysis parameter data DS22b and DS23b, all of which are prepared for the structure analysis data DS22 and the heat analysis data DS23, or the like can be utilized in the performance evaluation in the designing of the lamp.

Moreover, the constitution data DS1 of the standard data DS is, as shown in FIG. 5, prepared in a data format of a hierarchical type, which is composed of: the component data part DS1a having the component data about the components used for the lamp; and the attribute data part DS1b having the attribute data about the attributes of the components. Thus, in the designing of the lamp, the information about the standard lamp, which includes the attributes such as the materials of the components used for the lamp, can be sufficiently utilized.

Moreover, the attribute data as described above can be also utilized for the performance evaluation of the lamp. For example, in the constitution data DS1 shown in FIG. 5, the structure analysis data DS11e and the heat analysis data DS11f, which are prepared for the body data DS11a, can be utilized in the structure analysis and the heat analysis of the lamp, together with the structure analysis data DS22 and the heat analysis data DS23, which are prepared in the performance data DS2. As the structure analysis data DS11e of the structure data DS1, for example, a specific gravity, a tensile strength, a flexural strength and the like are prepared. Moreover, as the heat analysis data DS11f, for example, a thermal conductivity, a specific heat, a volume expansion rate and the like are prepared.

Note that the data format of the standard data DS shown in FIGS. 4 to 6 is similarly used in the design data generated by the standard data selected from the standard database 21 and updated according to need. For example, in the updating of the design data, the design data can be updated by changing a necessary data part of the respective data included in the standard data DS.

Next, description will be made for the design screen displayed on the display unit 5 in the vehicular lamp design system 1 shown in FIG. 1.

In the design system 1 shown in FIG. 1, for the designer performing designing of the lamp, the input unit 4 as the input means for inputting information related to the designing of the lamp and the display unit 5 as the display means for displaying information referred to in the designing of the lamp are provided. The designer can prepare the lamp data while exchanging information between the designer and the lamp preparation unit 3 via the above-described input unit 4 and display unit 5.

For example, in the design procedure of the vehicular lamp, as shown in the flowchart of FIG. 3, the designer refers to the design conditions given to the lamp to be designed and selects the standard data used as the source data of designing the lamp from the plurality of standard data registered in the standard database 21. In this event, a design screen showing the plurality of standard data registered in the standard database 21 as options of the design data is displayed on the display unit 5 of the design system 1. Thus, the designer can efficiently perform selection of the standard data by referring to contents displayed on the design screen.

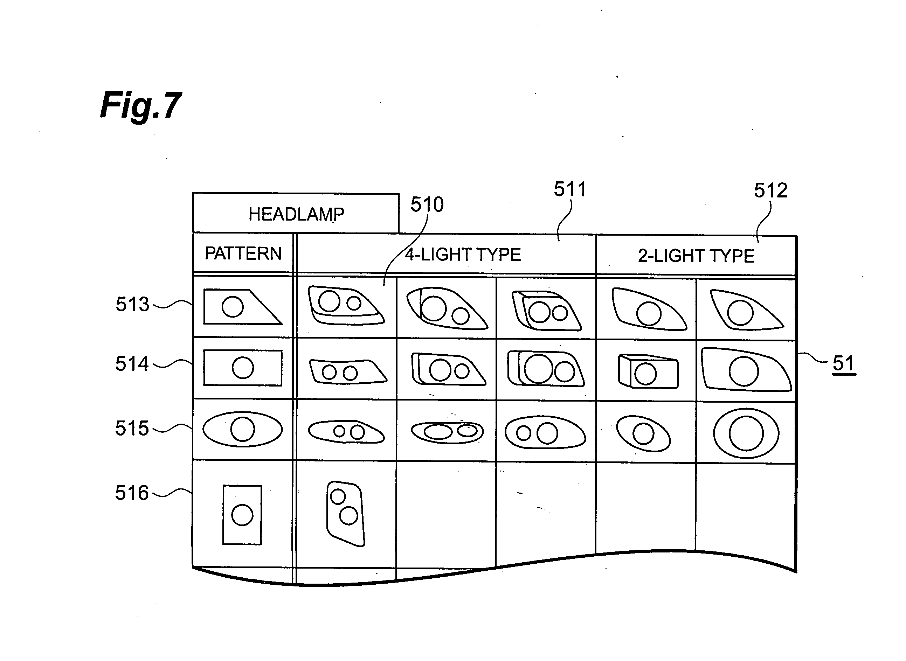

FIG. 7 is a view showing one example of the design screen displayed on the display unit 5 for the selection of the standard data. This design screen 51 shows a selection screen of the standard data, which is displayed when performing designing of a headlamp as the vehicular lamp.

In this design screen 51, the horizontal direction of the screen 51 is divided into a 4-light type section 511 and a 2-light type section 512 in accordance with the light type of the headlamp. Moreover, in accordance with pattern shapes of the headlamp, the vertical direction of the screen 51 is divided into: a irregular shape type section 513; a laterally long square type section 514; a circle type section 515; and a longitudinally long square type section 516. Then, in respective item sections 510, images of standard lamps corresponding to standard data, which are categorized according to these light types and pattern shapes, are displayed. The designer can refer to the contents displayed on the design screen 51 and can select the standard data used in the designing from the standard data shown in the item sections 510, respectively.

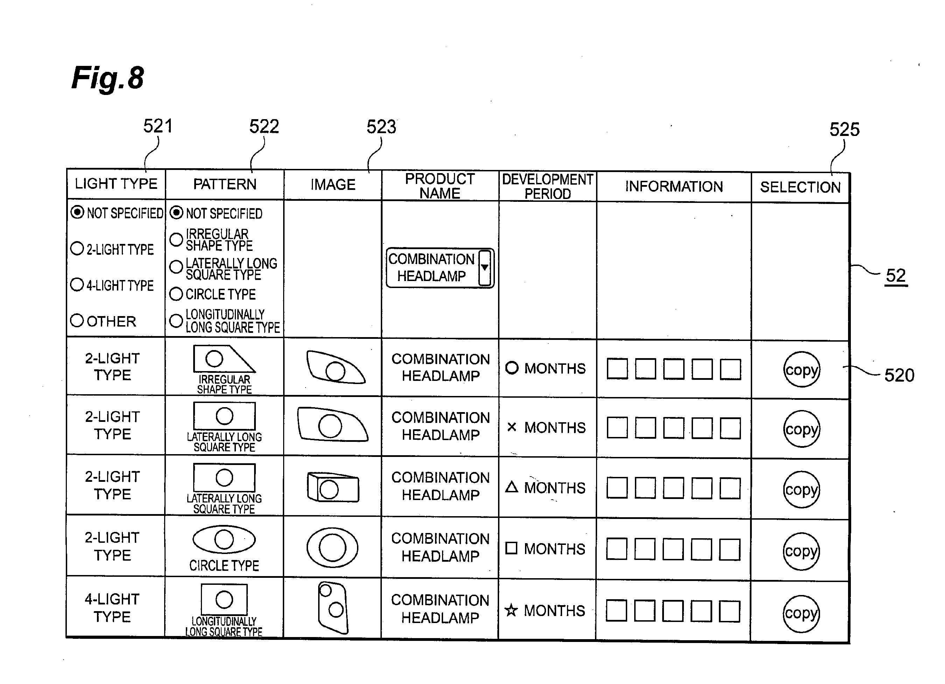

FIG. 8 15 a view showing another example of the design screen displayed on the display unit 5 for the selection of the standard data. This design screen 52 shows a selection screen of the standard data, which is displayed when performing the designing of the headlamp, similarly to that of FIG. 7.

In this design screen 52, the vertical direction of the screen 52 is divided into a plurality of sections, and the respective sections serve as item sections 520 displaying the standard data. Moreover, in the respective item section 520, display sections such as a light type display section 521, a pattern display section 522, an image display section 523 and the like are provided. The designer can refer to the contents displayed on the design screen 52 and can select the standard data used in the designing from the standard data shown in the item sections 520, respectively, by use of a selection instruction section 525.

Moreover, in the design procedure of the vehicular lamp, besides the selection of the above-described standard data, the designer, as shown in the flowchart of FIG. 3, refers to the given design conditions, makes a confirmation as to design data generated from the selected standard data and updates a part of or all of the design data according to need. In this event, if an design screen showing the contents of the design data at respective time points of the lamp designing is displayed on the display unit 5 of the design system 1, the designer can refer to the contents displayed on the design screen and can confirm and update the design data efficiently.

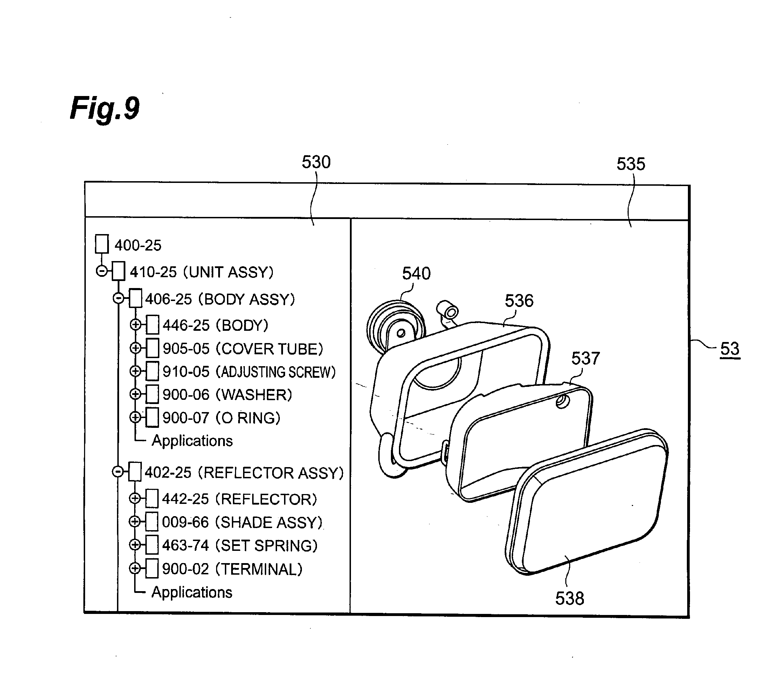

FIG. 9 is a view showing one example of a design screen displayed on the display unit 5 for confirming or updating the design data.

In this design screen 53, the left side thereof is a data display part 530, and the right side thereof is an image display part 535. In the data display part 530, contents of design data having the data formats shown in FIGS. 4 to 6 are displayed along with its hierarchical structure. Moreover, in the image display part 535, an image showing a structure of a lamp corresponding to the design data are displayed.

In the example shown in FIG. 9, in the image display part 535, displayed are: a body assembly 536 corresponding to the body assembly data DS11 in the constitution data DS1 (see FIG. 5); a reflector assembly 537 corresponding to the reflector assembly data DS12 therein; a lens assembly 538 corresponding to the lens assembly data DS13 therein; and a back cover assembly 540 corresponding to the back cover assembly data DS15 therein.

According to the design screen 53 as described above, the designer can refer to the contents displayed on the design screen 53, can confirm the contents of the design data at the respective time points of the lamp designing from the data shown in the data display part 530 and the image display part 535, respectively, or can instruct updating of a necessary data part.

The design method and design system for a vehicular lamp, program for allowing a computer to execute designing of the vehicular lamp and computer-readable record medium recording the program according to the present invention are not limited to the above-described embodiment but various changes thereof are possible. For example, in the design system 1 shown in FIG. 1, when it is unnecessary to perform the performance evaluation of the lamp and the like in the design system, the design system may have a constitution having no lamp evaluation unit 6 provided therein.

Moreover, as to the data format of the standard data of the lamp in the standard database 21, the data format shown in FIGS. 4 to 6 is one example thereof, and thus a data format other than the above may be used. For example, in the case where the performance of the lamp can be easily derived from the constitution data, 'a data format having no performance data may be adopted.

As described above in detail, the design method, design system, program for allowing a computer to execute designing of the vehicular lamp and computer-readable record medium recording the program for a vehicular lamp according to the present invention achieve effects as below. Specifically, in the design method, design system and the like, the standard database registering the standard data corresponding to the selected standard lamp is previously prepared, the design data are generated by selecting one piece of standard data from the standard database, a necessary part of the design data are updated, and thus the lamp data satisfying the design conditions are prepared. According to the above-described method and system, a design method, design system and the like for a vehicular lamp are realized, which can improve an efficiency of designing a lamp satisfying design conditions including performance conditions required as the vehicular lamp and restriction conditions given to each lamp.

## Claims

1. A design method for designing a vehicular lamp, the method comprising the steps of:
previously registering standard data in a standard database, the standard data being prepared in a predetermined data format having at least constitution data about a constitution of a standard lamp selected from lamps already designed; and
generating design data by selecting one piece of standard data from the plurality of standard data registered in said standard database based on design conditions including a performance condition required as the vehicular lamp and a restriction condition given to each lamp and preparing lamp data satisfying the design conditions by updating a necessary part of the design data;

2. The design method for a vehicular lamp according to claim 1, wherein the standard data are prepared in the data format having performance data about performance of the standard lamp in addition to the constitution data.

3. The design method for a vehicular lamp according to one of claims 1 and 2, wherein the constitution data are prepared in a data format of a hierarchical type, having component data about components used for the standard lamp and attribute data about attributes of the components in the component data.

4. A design system for designing of a vehicular lamp, the system comprising:
a standard database previously registering standard data prepared in a predetermined data format having at least constitution data about a constitution of a standard lamp selected from already designed lamps; and
lamp preparation means for generating design data by selecting one piece of standard data from the plurality of standard data registered in said standard database based on design conditions including a performance condition required as the vehicular lamp and a restriction condition given to each lamp and for preparing lamp data satisfying the design conditions by updating a necessary part of the design data.

5. The design system for a vehicular lamp according to claim 4, further comprising:
display means for displaying, as options of the design data, the plurality of standard data registered in said standard database; and
selection instruction means for instructing said lamp preparation means to select one piece of standard data to be the design data from the plurality of standard data.

6. The design system for a vehicular lamp according to one of claims 4 and 5, wherein the standard data are prepared in the data format having performance data about performance of the standard lamp in addition to the constitution data.

7. The design system for a vehicular lamp according to one of claims 4 to 6, wherein the constitution data are prepared in a data format of a hierarchical type, having component data about components used for the standard lamp and attribute data about attributes of the components in the component data.

8. A program for allowing a computer to execute designing of a vehicular lamp, the program being for allowing the computer to execute:
a lamp preparation processing in which design data are generated by selecting one piece of standard data from a plurality of standard data registered in a standard database based on design conditions including a performance condition required as the vehicular lamp and a restriction condition given to each lamp and lamp data satisfying the design conditions are prepared by updating a necessary part of the design data;
wherein said standard database is a database previously registering the standard data prepared in a predetermined data format having at least constitution data about a constitution of a standard lamp selected from lamps already designed.

9. The program according to claim 8, allowing the computer to further execute:
a display processing for displaying the plurality of standard data registered in said standard database, as options of the design data, on display means; and
a selection instruction processing for instructing selection of one piece of standard data to be the design data from the plurality of standard data.

10. The program according to one of claims 8 and 9, wherein the standard data are prepared in the data format having performance data about performance of the standard lamp in addition to the constitution data.

11. The program according to one of claims 8 to 10, wherein the constitution data are prepared in a data format of a hierarchical type, having component data about components used for the standard lamp and attribute data about attributes of the components in the component data.

12. A computer-readable record medium recording a program for allowing a computer to execute designing of a vehicular lamp, the program being for allowing the computer to execute:
a lamp preparation processing in which design data are generated by selecting one piece of standard data from a plurality of standard data registered in a standard database based on design conditions including a performance condition required as the vehicular lamp and a restriction condition given to each lamp and lamp data satisfying the design conditions are prepared by updating a necessary part of the design data;
wherein said standard database is a database previously registering the standard data prepared in a predetermined data format having at least constitution data about a constitution of a standard lamp selected from already designed lamps.

13. The record medium according to claim 12, wherein the program allows the computer to further execute:
a display processing for displaying the plurality of standard data registered in said standard database, as options of the design data, on display means; and
a selection instruction processing for instructing selection of one piece of standard data to be the design data from the plurality of standard data.

14. The record medium according to one of claims 12 and 13, wherein the standard data are prepared in the data format having performance data about performance of the standard lamp in addition to the constitution data.

15. The record medium according to one of claims 12 to 14, wherein the constitution data are prepared in a data format of a hierarchical type, having component data about components used for the standard lamp and attribute data about attributes of the components in the component data.
